# EUROPEAN PATENT SPECIFICATION

(11) **EP 4 536 422 B1**
(45) Date of publication and mention of the grant of the patent: **03.12.2025**
(21) Application number: 23734057.5
(22) Date of filing: 05.06.2023
(51) Int. Cl.: B21F 23/00, B21F 1/04, H05B 3/86, H05K 3/10, B32B 17/10

(54) **IMPROVED DEVICE FOR APPLYING FILIFORM MATERIAL ON A SUBSTRATE**
VERBESSERTE VORRICHTUNG ZUM AUFBRINGEN VON FADENFÖRMIGEM MATERIAL AUF EIN SUBSTRAT
DISPOSITIF AMÉLIORÉ POUR APPLIQUER UN MATÉRIAU FILIFORME SUR UN SUBSTRAT

(30) Priority: 09.06.2022 IT 202200012227
(43) Date of publication of application: 16.04.2025
(73) Proprietor: Easy Automation S.r.l., 00071 Pomezia (IT)
(72) Inventor: VINCENZI, Augusto, 00125 Roma (IT)
(74) Representative: Papa, Elisabetta
(86) International application number: PCT/IB2023/055749
(87) International publication number: WO 2023/237997

(56) References cited:
- EP-A1- 0 496 669
- EP-A2- 0 788 294
- WO-A1-2020/084438
- DE-A1- 102010 014 425
- DE-B3- 10 316 388
- US-A- 5 891 280

## Description

### Technical field of the invention

The present invention relates to the apparatuses for implementing composite materials, in particular with vitreous matrices, for thermoregulation applications.

The present invention, more in details, relates to a device configured for implementing laminated glass panels, in particular in the automotive sector, which integrate filaments made of conductive material inside thereof.

### Background

The use of composite materials, especially with vitreous matrices, is known in applications requiring a control of the thermo-hygrometric properties of the environments, for example in the construction and *automotive* field.

Regarding the latter, it is known it is known to implement the crystals of the transportation means in laminated glass, in order to provide them with their own heating system that eases the visual task of passengers by reducing the condensation phenomena in the passenger compartment.

Said crystals structurally provide one or more intermediate layers of polymeric material, comprised between two or more layers of vitreous material. A lattice of filaments made of conductive material, almost invisible to the naked eye and crossed by electric current, is "drowned" in one of these polymer layers.

More in details, the conductive material is deposited onto the polymeric layer through dedicated application devices which arrange it by following specific orientations, typically according to predetermined waveforms, to reduce to the minimum unwished phenomena of optical distortion. An application example is disclosed in the document DE 10 2010 014425 A1.

However, the need for improving said application devices is felt, which have disadvantages in terms of controlling the adjustment of the wire deposition parameters, thus penalizing the quality of the finished product.

In particular, the known application devices have difficulties in applying filaments with waveform "synchronous" to each other, that is filaments which, once deposited, have a substantially parallel arrangement along a prevailing direction of deposition and so as to have the waveform ridges and valleys in phase with each other. Such arrangement has the advantage of being able to apply greater currents which guarantee performances even on glasses with several layers, such as those used in the aeronautical, aerospace, naval field, in the field of armoured glasses and trains.

Currently these "synchronous" applications are substantially based upon two operating principles: the fact of providing an application unit in order to drown the wire in the (polymer) substrate which coincides with the element guiding the deposition of the wire itself and the fact of providing a motion of said guiding element through a mechanical actuation of piston rod-crank type, in which the motor has one single rotation direction.

Moreover, typically the above-mentioned element guiding the deposition of the wire is substantially constrained to abut at a constant distance with respect to the surface of the polymer substrate, with allowed variations in the order of half diameter of the applied wire (generally comprised between 15 and 30 microns) to obtain a correct application. For this reason usually such applications are implemented on workbenches (for example tables) with limited size by supporting the polymer by a glass plate so as to guarantee high planarity standards.

The drawbacks and limitations of the known solutions then are several and relate to a general complexity of the adjustments of the element guiding the deposition of the wire which, since it has to apply with predefined accuracy, distance, planarity and orientation, is typically moved with reduced application speeds, typically not higher than 25 millimetres per second.

It is also impossible to modify the waveform of the filament being applied on the substrate except with a setting intervention of the piston rod-crank actuation group which cannot be performed during application but exclusively when the machine is stationary and in a configuration phase preliminary to the working cycle.

An additional disadvantage of the known devices lies in the required re-positioning of the polymeric layer on the workbench during application due to the use of tables with reduced sizes. Moreover, even when a glass support is used to increase the planarity of the polymeric substrate, however it is not possible to use vacuum planes to guarantee the perfect stretching of the polymeric substrate on the workbench, by risking to produce errors during the wire application due to the possible presence of wrinkles of said substrate.

### Summary of the invention

The technical problem placed and solved by the present invention is then to overcome the above-illustrated problems, and this is obtained through a device configured to apply a wire on a substrate as defined in claim 1.

In particular, an object of the present invention is to provide a device configured to apply a wire on a substrate which allows to modify the wire application parameters, such as for example the length and the width of the waveform and the deposition route, instantaneously during application.

An additional object of the present invention is to provide a device configured to apply a wire on a substrate wherein said application is self-adapting with respect to the working conditions and wherein the motion generating the filament waveform comes from an actuation independent from kinematic chains providing crank mechanisms.

An object of the present invention is also to provide a device configured to apply a wire on a substrate allowing to act on working supports with high sizes and with a vacuum plane, by avoiding the re-positioning of the polymeric substrate and by reducing the risk of the presence of wrinkles on the latter.

An additional object of the present invention is to provide a device configured to apply a wire on a substrate acting with high precision and rapidity features, in particular with application speeds which can reach 450 millimetres per second.

An object of the present invention is also to provide a device configured to apply a wire on a substrate providing a high-quality finished product.

Additional features of the present invention are defined in the corresponding depending claims.

The present invention relates to a device configured to apply a wire made of electrically conductive material on a substrate. Said device comprises guiding means for supporting the wire and guiding the deposition on the substrate and an application unit placed at said guiding means. The application unit is movable between a first condition raised with respect to the substrate and a second condition of contact with the wire and the substrate.

Said application unit and said guiding means are actuated by motor means configured to allow a rotation of the guiding means between two predetermined angular positions with respect to a translation axis of the application unit which results to be orthogonal to the substrate.

It will be appreciated that such solution allows to overcome the reduced application flexibility of the known solutions, wherein the guiding system is typically associated to piston rod-crank mechanisms, in order to obtain the motion required to the wire deposition according to pre-established patterns, in particular the motion "inversions" - or swings - of the guiding means comprised between the above-mentioned predetermined angular positions which allow to implement waveforms with crests and bellies.

Advantageously, the motor means of the device of the invention comprises an electric motor with two main functional elements, that is a stator element and a rotor element integral with the guiding means, by simplifying the actuation and by improving the dynamics of the implementation chain for a quicker (in the order of 100 inversions per second) and precise application of the wire on the substrate. The application unit of the device then can receive the wire from the guiding means in the wished position and, under contact conditions, it can press it in the substrate.

Advantageously, the device comprises heating means and the application unit is made of metal to allow the application of the wire in the support (polymer) by softening of the same by using two synergic technologies: a heating of the substrate and of the wire through contact heat transfer, since the application unit can be heated at a temperature higher than that of the substrate, in combination with or alternatively to a heating of the wire by current passage.

It will be appreciated that such solution advantageously allows to obtain a device which guarantees high flexibility in applying the wire on the substrate while maintaining extreme precision during deposition.

According to an additional advantageous aspect of the invention, the device can include deformation, or dragging, means, which comprises at least a pair of wheels which circumferentially carry a plurality of wire deformation elements. In particular, said plurality of deformation elements is configured to come in contact with the wire in an engagement region and, then, to deform it. The wire then can be not only guided, but even deformed plastically during application according to a predetermined waveform, in case it is necessary to contrast possible residual tensions inside the wire.

Other advantages, together with the features and the use modes of the present invention, will result evident from the following detailed description of preferred embodiments thereof, shown by way of example and not for limitative purposes.

### Brief description of figures

The drawings reported in the enclosed figures will be referred to, wherein:
- Figure 1 shows an overall perspective view of the device configured to apply a wire made of electrically conductive material on a substrate, according to a preferred embodiment of the present invention;
- Figure 2 shows a portion, in particular relating to the guiding means and to the application unit, of the device illustrated in Figure 1;
- Figure 3 shows a cut-out of a preferred embodiment relating to the guiding means and to the application unit of the wire illustrated in Figure 2;
- Figure 4 shows an overall perspective view of the device illustrated in Figure 1 optionally provided with wire deformation means.

### Detailed description of possible embodiments of the invention

The present invention will be described hereinafter by making reference to the above-mentioned figures.

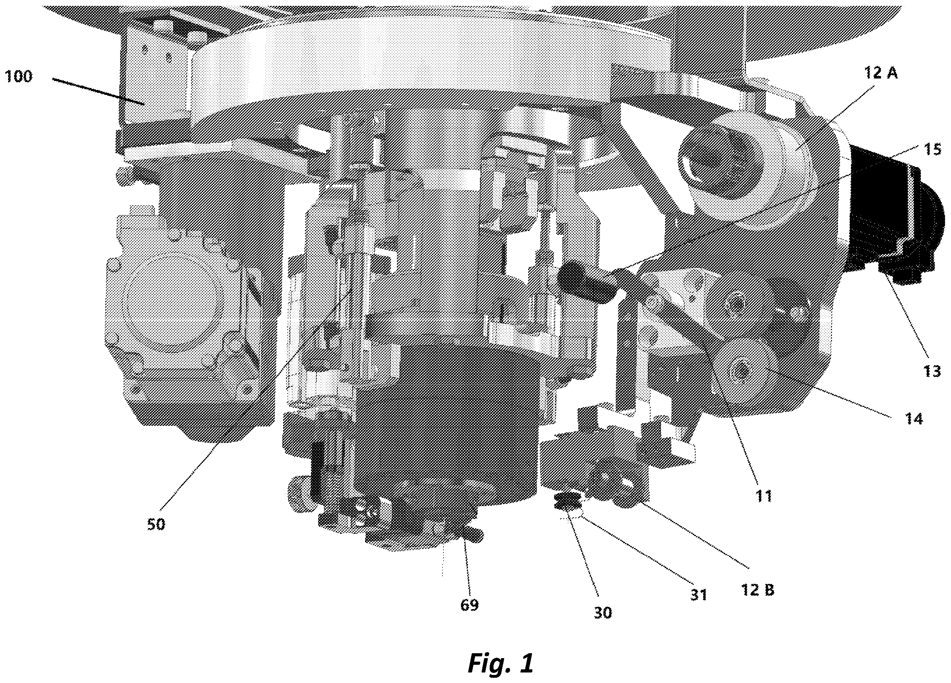

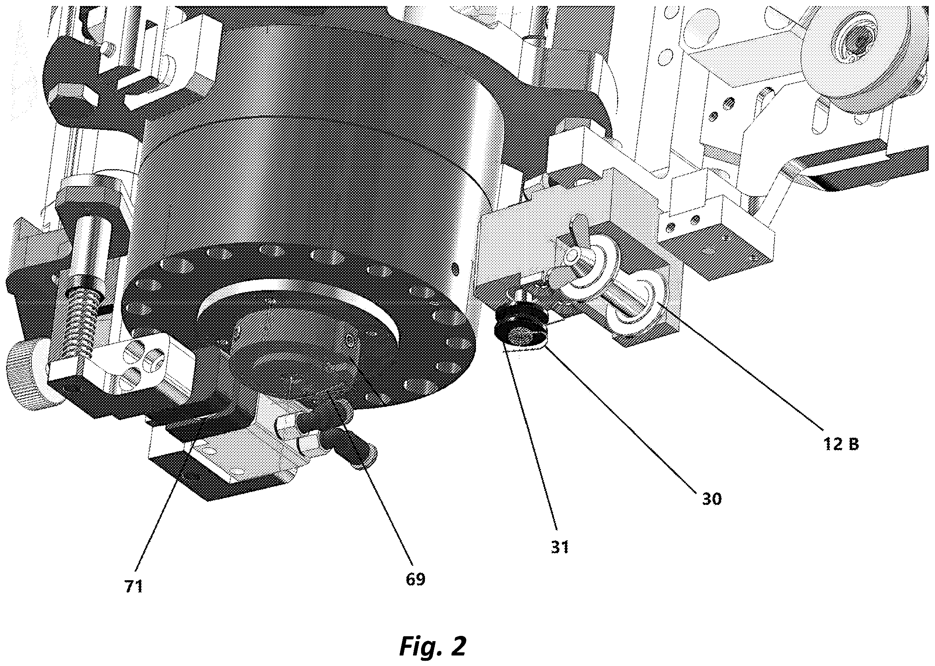

By firstly referring to Figure 1 and Figure 2, a preferred embodiment of a device for applying a wire made of electrically conductive material, designated as a whole with reference 100, is illustrated. Said device is intended to be used in the productive processes relating the implementation of composite materials, preferably in stations for implementing components for the automotive, aeronautical, naval, railway industry, in particular for the implementation of glasses, formed by a sandwich comprising vitreous material and plastic material.

Still more preferably, the device the present invention relates to, can be applied in the implementation of windscreen made of laminated glass or composite glass, wherein an intermediate layer of plastic material, such as for example Polyvinyl butyral (PVB), is interposed between one or more layers (or films) of vitreous material and it is adapted to receive the wire made of electrically conductive material which remains "drowned" therebetween.

The wire, not shown in Figures and suitable to be applied by the device 100, preferably is a wire made of tungsten and it allows the electrified heating of the glass to keep good visibility even under adverse weather conditions, such as ice formation or condensation formation.

Physical properties and dimensional features of wires of such type are on themselves within the comprehension of the person skilled in the art and for this reason one will not further dwell thereupon hereinafter.

The device 100 according to the invention can further allow to implement products characterized by properties similar to the just mentioned ones, but intended to different uses, such as for example glasses in the construction field or for architecture projects.

The device 100 preferably is configured to cooperate, under operating conditions, with an apparatus - not shown in figures - which receives a substrate whereon the wire is deposited. As said, the substrate preferably is made of plastic material and it can be received on the surface of a workbench, preferably a table (plotter), for an omnidirectional application of the wire.

According to a preferred operating mode of the device 100, the wire is applied on the substrate according to a prevailing direction of longitudinal deposition and so as to form a *pattern,* or motif, consisting of filaments spaced apart from each other and oriented parallelly. Each filament has a waveform wherein, preferably, crests and bellies result to be in "phase" with each other.

It will be appreciated that the invention advantageously allows an accurate parallel application of the filiform material and "in phase" of the waveform, as it will be described in greater detail hereinafter.

The device 100, in general terms, is provided with means for feeding the wire which can be configured even to adjust the application speed. Said feeding means comprises a control element, for example comprising sensors, such as a dancer control designated as a whole with references 11, 14 and 15. Such control element allows to adjust the speed for unwinding the wire, for example depending upon the motion of the workbench which receives the substrate or predetermined parameters for tensioning the wire which one wishes to set/keep during application.

The wire can be supported by one or more coils 12A and 12B whereon it is wound or even in remote position with respect to the device 100. The wire unwinding, in embodiments, can be assisted by unwinding means, such as motorized coils 13.

The device 100 further comprises means for supporting the wire and guiding the deposition thereof on the substrate according to said, predetermined and preferably high-frequency sinusoidal, motifs and a movable application unit configured to keep constant its own distance from the substrate during application. Such application preferably is obtained through a combined heating by conduction and passage of current on the wire itself, as it will be explained in details hereinafter.

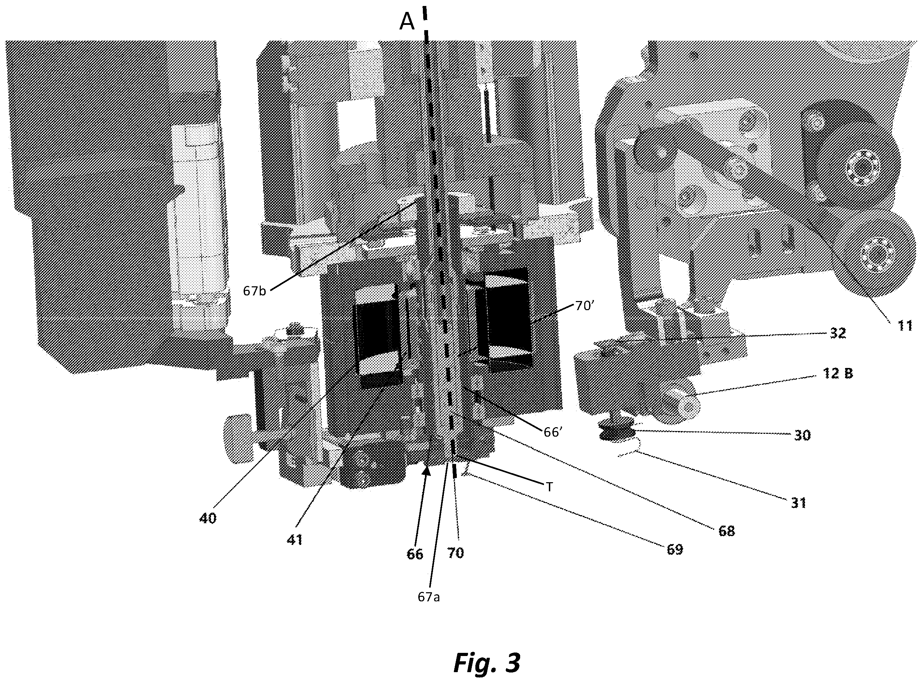

By further referring to Figure 3, the application unit - designated as a whole with reference 70 - is placed at the guiding means - designated as a whole with reference 66 - and it is movable between a first condition raised with respect to the substrate and a second condition of contact with the wire and the substrate. The Figure shows the application unit under raised condition with respect to the substrate.

Motor means of the device 100 allow the translation of the application unit 70 along an axis A which, upon using the device 100, results to be orthogonal to the substrate. In particular, application cylinders 50, for example low-friction pneumatic cylinders, allow to raise or lower the application unit 70 with respect to the substrate.

A control unit of the device 100 is configured to control the motor means, the guiding means 66 and the application unit 70. Advantageously, the device 100 allows to modulate the application pressure of the wire on the substrate by the application unit 70 by means of the control unit and the application cylinders 50.

The guiding means 66 of the wire is movable in rotation between two predetermined angular positions around said translation axis A of the application unit 70. In other terms, the guiding means swing between the two predetermined angular positions.

In a preferred embodiment, the motor means comprises an electric motor equipped with a stator element 40 and a rotor element 41 integral with said guiding means 66.

Advantageously, then, the two predetermined angular positions can be obtained depending upon the rotation frequency of the rotor element 41.

The guiding means 66 of the wire, i.e., support the wire and they have the purpose of positioning the wire in the requested position for its subsequent application in the substrate by means of the application unit 70. The frequency associated to the rotation of the rotor element 41 can reach 50 Hz or equivalent frequencies in order to obtain even 100 inversions or swings (that is reaching the two predetermined angular positions) per second. As said, the control unit of the device 100 controls the correct actuation of the guiding means 66 with respect to the project specifications. Such actuation can be set through a software interface (Ewibe).

As it can be seen in Figures, the guiding means 66 preferably result to be interposed between the motor means, in particular the rotor element 41, and said application unit 70. In the illustrated embodiment, the guiding means comprises a hollow housing 66', preferably shaped like a cylindrical element, having end openings 67a, 67b and arranged coaxially to said rotor element 41.

Said hollow housing 66' is configured to house internally the application unit 70. An annular air gap remains defined between the internal face of the hollow housing 66' and the application unit 70 in order to guarantee the translation of the latter.

In particular, the application unit preferably comprises a metal body 70' slidingly movable inside the hollow housing 66'. Under the contact condition of the application unit 70, a terminal portion T of the metal body 70' passes through an opening 67a of the hollow housing 66' which faces the substrate. As mentioned above, by adjusting the sliding of the application unit 70 it is possible to compensate automatically possible differences in level present in the substrate, by raising or lowering the application unit 70 so that it constantly remains in contact with the wire and the substrate during the above-mentioned contact condition.

The hollow housing 66' is coupled to the rotor element 41 and rotates integrally therewith. Preferably, a support element of the wire, such as a ferrule 69, projects from an end of the hollow housing 66' placed at the opening 67a which faces the substrate. Such ferrule 69 is integral with the motion of the hollow housing 66' and it is preferably implemented in the form of an eyelet crossed by the wire to be deposited.

The wire, supported by the ferrule 69, performs the swinging motion of the latter between the two predetermined angular positions and it is positioned according to the wished waveform to be subsequently pressed on the substrate by the terminal portion T of the application unit 70. The application unit 70 results to be placed downwards of said ferrule 69 with respect to a direction of feeding of the wire into the device 100.

Preferably, the device 100 further comprises heating means of the application unit 70 and/or of the wire. Said heating means comprises an electrical resistance 68 carried by the application unit and electrifiable support means of the wire.

In particular, the heating means allows to transfer heat to the wire by conduction, that is to heat the metal body 70' through electrical resistance 68 and then the terminal portion T whereon the wire slides during the contact condition. The heating means preferably also allows the circulation in the wire of a current by applying a potential difference, for example of the order of some volts, in the wire tract comprised between the terminal portion T of the metal body 70' and said electrifiable support means, illustrated in Figures like a wheel 30 whereon the wire and a spring 31, fed through contact 32, are wound.

A heating of the wire which provides the joint use of the above-mentioned systems allows the device 100 to apply the wire with greater speeds, for example up to 450 millimetres/second (mm/sec), and at lower temperatures, lower than 200°C and preferably comprised around approximately 100°C, with respect to the known solutions, by reducing among other things stress phenomena on the substrate which, since, as said, preferably is made of plastic material, does not like to receive the application filiform material at high temperatures.

However, advantageously, the control unit is configured to allow an adjustment of the operating parameters of the heating means, for example of the temperature of the application unit 70 through the electrical resistance 68 and of the applied potential difference, programmable with a control panel by an operator.

Preferably, the device 100 comprises a cutting unit 71 configured to cut the wire once the application has ended and to re-start with a subsequent application. In the illustrated example, the cutting unit 71 comprises a locking - or punching - component which locks feeding the wire and a properly cutting component. The cutting unit 71 is preferably positioned downstream of the heating means, in particular downstream of the application unit 70 with respect to said direction of feeding the wire into the device.

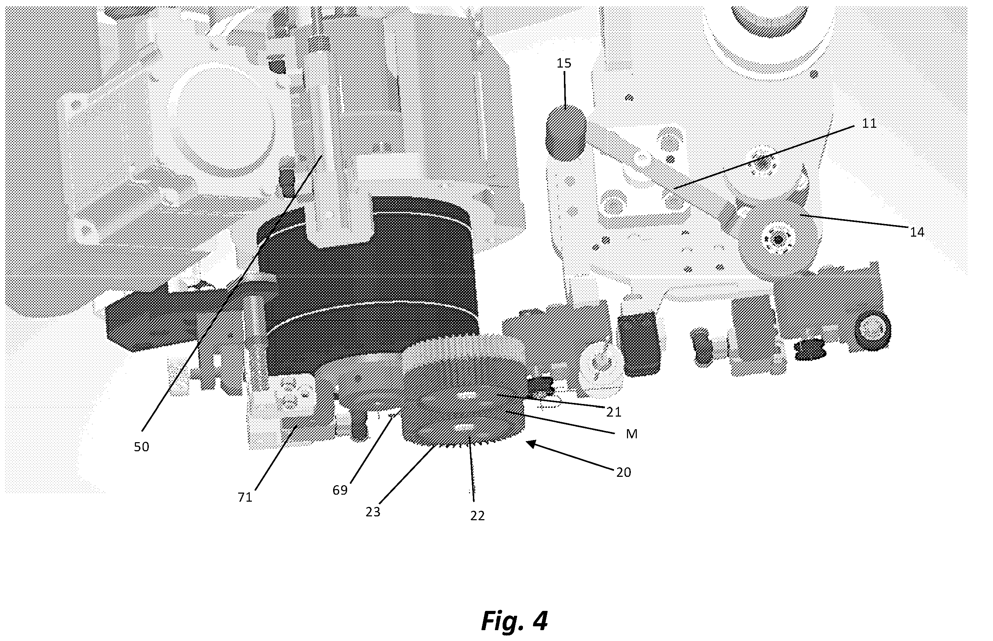

By now referring to Figure 4, an alternative schematic embodiment of the device 100 is shown comprising deformation, or drugging, means designated as a whole with reference 20 and comprising a pair of wheels 21, 22 which circumferentially carry a plurality of deformation elements 23 of the wire.

The plurality of the deformation elements 23 is configured to come in contact with the wire in an engagement region M and to deform it.

The device 100, substantially, allows to keep aligned and stretched the wire until the latter reaches said pair of wheels 21, 22 so that the deformation elements carried by them could deform it before it is deposited - according to a predetermined waveform - on the substrate.

A wire applied on the substrate, in fact, could produce tensions inside the glass so as to cause optical distortions. The wire then can be deformed, preferably according to a sinusoidal (or cosinusoidal) waveform and subsequently guided by guiding means 69 in an application according to the wished waveform and so that not residual tensions take place in the final product.

The deformation means 20 comprises, as said, at least a pair of wheels 21, 22. They support the deformation elements 23, implemented for example like a pin or tooth shape, which could extend in an onboard annular surface of the wheels 21, 22 or even develop in an annular region extending along an axial direction from the onboard annular surface.

According to a preferred embodiment of the present invention, the deformation elements 23 of a first wheel 21, by rotating, occupy the free space between the deformation elements of a second wheel 22 of said at least a pair of wheels, in reality by implementing a sort of "contactless" engagement between the two wheels in the engagement region M. The first and the second wheel 21, 22 have an opposite rotation direction and, preferably, the respective rotation axes are parallel therebetween.

Moreover, the deformation means 20 is further connected with the previously mentioned means for feeding and adjusting the application speed 11 of the wire, through the control unit. The device 100, i.e., is configured to deform the wire preferably depending upon its tensioning, its forwarding speed or application speed, the latter for example parameterized depending upon the apparatus which receives the substrate.

The wire, during application, preferably is deformed more than it results once it has been applied on the substrate. In this sense, the device 100 applies a slight tension because, advantageously, it eases to keep the wire through the guiding means, in particular through the ferrule 69, and with respect to a predetermined application position on the substrate. Such tensioning is obtained through an adjustment of one or more control parameters performed by the control unit which, by controlling the rotation speed of the pair of wheels 21, 22, allows the wire to come out from the engagement region M with a slower forwarding speed than the speed at which it results to be applied on the substrate.

The present invention has been sofar described with reference to preferred embodiments thereof. It is to be meant that each one of the technical solutions implemented in the preferred embodiments, herein described by way of example, can advantageously be combined, differently from what described, with the other ones, to produce other embodiments, belonging to the same inventive core and however all within the protective scope of the herebelow reported claims.

## Claims

1. A device (100) configured to apply a wire made of electrically conductive material on a substrate, which device (100) comprises:
▪ guiding means (66) for supporting the wire and guiding the deposition on the substrate,
▪ an application unit (70) placed at said guiding means (66) and movable along a translation axis (A) orthogonal to the substrate between a first condition raised with respect to the substrate and a second condition of contact with the wire and the substrate,
▪ motor means (40, 41, 50) configured to allow a rotation of said guiding means (66) and the translation of said application unit (70) along said translation axis (A),
wherein said guiding means (66) is rotatable between two predetermined angular positions around said translation axis (A) of said application unit (70).

2. The device (100) according to claim 1, wherein said motor means comprises an electric motor equipped with a stator element (40) and a rotor element (41) integral with said guiding means (66).

3. The device (100) according to claim 1 or 2, wherein said two predetermined angular positions are obtained in function of the rotation frequency of said rotor element (41).

4. The device (100) according to claim 2 or 3, wherein said guiding means (66) is interposed between said motor means (40, 41) and said application unit (70) and comprises a hollow housing (66') coaxial to said rotor element (41) and shaped so as to internally house said application unit (70).

5. The device (100) according to the preceding claim, wherein said guiding means comprises a support element (69) of the wire integral with said hollow housing (66'), which projects externally from the hollow housing (66') and faces the substrate.

6. The device (100) according to any one of the preceding claims, wherein said application unit (70) comprises a metal body (70') slidingly movable inside said hollow housing (66'), wherein said metal body (70') passes through an opening (67a) of said housing (66') which faces the substrate when the application unit (70) is in the second contact condition.

7. The device (100) according to any one of the preceding claims, further comprising heating means (30, 31, 68) of the application unit (70) and/or of the wire.

8. The device (100) according to the preceding claim, wherein said heating means comprises an electrical resistance (68) carried by the application unit (70) and electrifiable support means (30, 31) of the wire.

9. The device (100) according to any one of the preceding claims, further comprising deformation means (20) of the wire arranged upstream of the guiding means (66) with respect to a direction of feeding the wire into the device (100).

10. The device (100) according to the preceding claim, wherein said deformation means comprises a pair of wheels (21, 22) which circumferentially carry a plurality of deformation elements (23) of the wire.

## Patentansprüche

1. Vorrichtung (100), die konfiguriert ist, um einen Draht, der aus elektrisch leitfähigem Material hergestellt ist, auf ein Substrat aufzubringen, wobei die Vorrichtung (100) umfasst:
▪ ein Führungsmittel (66) zum Stützen des Drahts und Führen der Abscheidung auf dem Substrat,
▪ eine Aufbringungseinheit (70), die an dem Führungsmittel (66) platziert ist und entlang einer Translationsachse (A) orthogonal zu dem Substrat zwischen einem ersten, in Bezug auf das Substrat angehobenen Zustand und einem zweiten, in Kontakt mit dem Draht und dem Substrat stehenden Zustand bewegbar ist,
▪ ein Motormittel (40, 41, 50), das konfiguriert ist, um eine Rotation des Führungsmittels (66) und die Translation der Aufbringungseinheit (70) entlang der Translationsachse (A) zu ermöglichen,
wobei das Führungsmittel (66) zwischen zwei zuvor bestimmten Winkelpositionen um die Translationsachse (A) der Aufbringungseinheit (70) herum rotierbar ist.

2. Vorrichtung (100) nach Anspruch 1, wobei das Motormittel einen Elektromotor, der mit einem Statorelement (40) und einem Rotorelement (41) integral mit dem Führungsmittel (66) ausgestattet ist, umfasst.

3. Vorrichtung (100) nach Anspruch 1 oder 2, wobei die zwei zuvor bestimmten Winkelpositionen in Abhängigkeit von der Rotationsfrequenz des Rotorelements (41) erhalten werden.

4. Vorrichtung (100) nach Anspruch 2 oder 3, wobei das Führungsmittel (66) zwischen dem Motormittel (40, 41) und der Aufbringungseinheit (70) eingeschoben ist und ein hohles Gehäuse (66') umfasst, das koaxial zu dem Rotorelement (41) ist und gestaltet ist, um die Aufbringungseinheit (70) intern aufzunehmen.

5. Vorrichtung (100) nach dem vorstehenden Anspruch, wobei das Führungsmittel ein Stützelement (69) des Drahts integral mit dem hohlen Gehäuse (66') umfasst, das nach außen aus dem hohlen Gehäuse (66') herausragt und dem Substrat zugewandt ist.

6. Vorrichtung (100) nach einem der vorstehenden Ansprüche, wobei die Aufbringungseinheit (70) einen Metallkörper (70'), der im Inneren des hohlen Gehäuses (66') verschiebbar ist, umfasst, wobei der Metallkörper (70') durch eine Öffnung (67a) des Gehäuses (66') hindurchgeht, die dem Substrat zugewandt ist, wenn sich die Aufbringungseinheit (70) in dem zweiten Kontaktzustand befindet.

7. Vorrichtung (100) nach einem der vorstehenden Ansprüche, ferner umfassend ein Heizmittel (30, 31, 68) der Aufbringungseinheit (70) und/oder des Drahts.

8. Vorrichtung (100) nach dem vorstehenden Anspruch, wobei das Heizmittel einen elektrischen Widerstand (68), der durch die Aufbringungseinheit (70) getragen wird, und ein elektrifizierbares Stützmittel (30, 31) des Drahts umfasst.

9. Vorrichtung (100) nach einem der vorstehenden Ansprüche, ferner umfassend ein Verformungsmittel (20) des Drahts, das in Bezug auf eine Zuführrichtung des Drahts in die Vorrichtung (100) dem Führungsmittel (66) vorgeschaltet angeordnet ist.

10. Vorrichtung (100) nach dem vorstehenden Anspruch, wobei das Verformungsmittel ein Paar Räder (21, 22) umfasst, die in Umfangsrichtung eine Vielzahl von Verformungselementen (23) des Drahts tragen.

## Revendications

1. Dispositif (100) conçu pour appliquer un fil fabriqué dans un matériau électroconducteur sur un substrat, ce dispositif (100) comprenant :
▪ un moyen de guidage (66) permettant de supporter le fil et de guider le dépôt sur le substrat,
▪ une unité d'application (70) placée au niveau dudit moyen de guidage (66) et déplaçable le long d'un axe de translation (A) orthogonal au substrat entre une première condition surélevée par rapport au substrat et une seconde condition de contact avec le fil et le substrat,
▪ un moyen moteur (40, 41, 50) conçu pour permettre une rotation dudit moyen de guidage (66) et la translation de ladite unité d'application (70) le long dudit axe de translation (A),
dans lequel ledit moyen de guidage (66) peut effectuer une rotation entre deux positions angulaires prédéterminées autour dudit axe de translation (A) de ladite unité d'application (70).

2. Dispositif (100) selon la revendication 1, dans lequel ledit moyen moteur comprend un moteur électrique équipé d'un élément stator (40) et d'un élément rotor (41) solidaire dudit moyen de guidage (66).

3. Dispositif (100) selon la revendication 1 ou 2, dans lequel lesdites deux positions angulaires prédéterminées sont obtenues en fonction de la fréquence de rotation dudit élément rotor (41).

4. Dispositif (100) selon la revendication 2 ou 3, dans lequel ledit moyen de guidage (66) est interposé entre ledit moyen moteur (40, 41) et ladite unité d'application (70) et comprend un logement creux (66') coaxial audit élément rotor (41) et mis en forme de façon à loger de façon interne ladite unité d'application (70).

5. Dispositif (100) selon la revendication précédente, dans lequel ledit moyen de guidage comprend un élément de support (69) du fil solidaire dudit logement creux (66'), qui fait saillie de façon externe du logement creux (66') et fait face vers le substrat.

6. Dispositif (100) selon l'une quelconque des revendications précédentes, dans lequel ladite unité d'application (70) comprend un corps métallique (70') déplaçable par coulissement à l'intérieur dudit logement creux (66'), dans lequel ledit corps métallique (70') passe à travers une ouverture (67a) dudit logement (66') qui fait face vers le substrat lorsque l'unité d'application (70) est dans la seconde condition de contact.

7. Dispositif (100) selon l'une quelconque des revendications précédentes, comprenant en outre un moyen de chauffage (30, 31, 68) de l'unité d'application (70) et/ou du fil.

8. Dispositif (100) selon la revendication précédente, dans lequel ledit moyen de chauffage comprend une résistance électrique (68) portée par l'unité d'application (70) et un moyen de support électrifiable (30, 31) du fil.

9. Dispositif (100) selon l'une quelconque des revendications précédentes, comprenant en outre un moyen de déformation (20) du fil agencé en amont du moyen de guidage (66) par rapport à une direction d'alimentation du fil dans le dispositif (100).

10. Dispositif (100) selon la revendication précédente, dans lequel ledit moyen de déformation comprend une paire de roues (21, 22) qui portent circonférentiellement une pluralité d'éléments de déformation (23) du fil.
